**Europäisches Patentamt**

**European Patent Office**

**Office européen des brevets**

(11) Veröffentlichungsnummer: **0 159 403**
A2

# EUROPÄISCHE PATENTANMELDUNG

(21) Anmeldenummer: 84115564.1

(51) Int. Cl.⁴: **H 03 M 13/00**

(22) Anmeldetag: **17.12.84**

(30) Priorität: **27.04.84 DE 3415765**

(71) Anmelder: **Siemens Aktiengesellschaft, Berlin und München Wittelsbacherplatz 2, D-8000 München 2 (DE)**

(43) Veröffentlichungstag der Anmeldung: **30.10.85 Patentblatt 85/44**

(84) Benannte Vertragsstaaten: **AT BE CH DE FR GB IT LI NL SE**

(72) Erfinder: **Erdel, Karlheinz, Dipl.-Ing., Rablstrasse 44, D-8000 München 80 (DE)**

(54) **Anordnung zur Korrektur von Bündelfehlern in verkürzten zyklischen Blockcodes.**

(57) Die Korrekturanordnung empfängt am Eingang (16) ein Codewort. Dieses wird dem Syndromregister (15) vollständig zugeführt. Enthält das Syndromregister Fehler anzeigende Einsen, so wird sein Inhalt solange zyklisch verschoben, bis eine Nullen-Erkennungseinrichtung (24) an den höherwertigen Registerstufen eine Nullenfolge anzeigt. Die restlichen Registerstufen enthalten dann, sofern der Fehler korrigierbar ist, das Fehlermuster, das im Exklusiv-ODER-Gatter (28) mit dem aus dem Pufferspeicher (26) ausgelesenen Codewort an der Stelle des Bündelfehlers modulo-2-addiert wird, was zur Eliminierung des Fehlers führt.

0159403

Siemens Aktiengesellschaft
Berlin und München

Unser Zeichen
VPA 84 P 1 3 3 2 DE

**Anordnung zur Korrektur von Bündelfehlern in verkürzten zyklischen Blockcodes.**

Die Erfindung bezieht sich auf eine Anordnung zur Korrektur von Bündelfehlern mit maximal b Stellen nach dem "Error-Trapping"-Verfahren in um i Stellen verkürzten zyklischen Blockcodes mit n Stellen, die sich aus r Stellen für einen Prüfteil und aus k Stellen für einen Informationsteil zusammensetzen, mit einem r Stufen aufweisenden Syndromregister, bei dem ein Gesamteingang über wenigstens ein zwischen diese Stufen geschaltetes Exklusiv-ODER-Gatter angeschlossen ist, dessen Lage aus den Koeffizienten eines Vormultiplikationspolynoms abgeleitet ist und bei dem der Ausgang der letzten Stufe über einen ersten Schalter mit dem Eingang der ersten Stufe und über wenigstens ein weiteres zwischen diese Stufen geschaltetes Exklusiv-ODER-Gatter mit weiteren Stufen verbunden ist, dessen Lage aus dem Generatorpolynom des Codes abgeleitet ist, mit einer r-b Stufen aufweisenden und an Stufen des Syndromregisters angeschlossenen Nullen-Erkennungseinrichtung, mit einem n Stufen aufweisenden und an den Gesamteingang angeschlossenen Pufferspeicher, mit einem letzten Exklusiv-ODER-Gatter, dessen einer Eingang mit dem Ausgang des Pufferspeichers, dessen anderer Eingang über einen zweiten Schalter mit dem Ausgang des Syndromregisters und dessen Ausgang mit einem Gesamtausgang verbunden ist, mit einer alle Schalter mit einem Synchronisierungssignal am Gesamteingang synchronisiert betätigenden Ablaufsteuerung und mit einer mit dem Bittakt des

Wke 1 Kom / 24.04.1984

am Gesamteingang anliegenden Empfangssignals synchronisierten Taktversorgung.

Eine derartige Anordnung ist aus dem Buch "Prüfbare und korrigierbare Codes" von W. Wesley Peterson, R. Oldenbourg-Verlag München und Wien, 1967, Seiten 256 bis 258, insbesondere Bild 10.4 bekannt.

Bei zyklischen Blockcodes insbesondere zur Korrektur von Bündelfehlern der Länge b ist das sogenannte "Error-Trapping"-Verfahren (Fehler-fang-Verfahren) ein übliches Korrekturverfahren. Ein zyklischer Blockcode ist durch sein Generatorpolynom $g(x)$ definiert.

Sendeseitig wird mittels eines Syndromregisters mit r Stufen dem Informationsteil ein Prüfteil nachgeordnet. Es entsteht so ein Codewort, das sich mathematisch als Polynom mit binären Koeffizienten darstellen läßt. Dieses Codewort kann bei der Übertragung verfälscht werden. Empfangsseitig wird es mit $v(x)$ bezeichnet.

Eine empfangsseitige Decodierung erfolgt ebenfalls mittels eines Syndromregisters mit r Stufen. Nach Eingabe des empfangenen Codeworts enthält dieses bei Fehlerfreiheit ausschließlich Nullen. Sind dagegen Fehler vorhanden, dann treten auch Einsen auf. Das Bitmuster im Syndromregister nach Eingabe des Codeworts wird als Syndrom bezeichnet.

Um nach der Decodierung sofort mit der Fehlerkorrektur beginnen zu können, wird üblicherweise eine automatische Vormultiplikation des als Polynom aufzufassenden n-stelligen Empfangsworts $v(x)$ mit dem Polynom $x^r$ vorgenommen. Das heißt schaltungstechnisch, daß das Empfangswort nach der letzten Stufe des Syndromregisters über ein Exklusiv-ODER-Gatter eingegeben wird. Nach Abschluß der Eingabe beginnt die Fehlerkorrektur. Dazu

0159403

- 3 -  VPA 84 P 1 3 3 2 DE

wird der Inhalt des Syndromregisters bei geschlossener Rückkopplung solange zyklisch verschoben, bis die ersten r-b Stufen nur Nullen enthalten. Die letzten b Stufen enthalten dann das Fehlermuster.

Soll der Blockcode um i Bits verkürzt werden, so werden die ersten i Bits des Informationsteils jedes Codeworts Null gesetzt und nach der Codierung weggelassen. Bei der Decodierung muß das gekürzte Codewort wieder mit i Nullen aufgefüllt werden. Das Anfügen von Nullen kann vermieden werden, wenn eine zusätzliche Vormultiplikation des empfangenen Codeworts mit dem Polynom $x^i$ vorgenommen wird, d.h. bei einem verkürzten Blockcode wird üblicherweise das Syndrom des mit dem Polynom $x^{r+i}$ multiplizierten Polynoms des empfangenen Codeworts v(x) berechnet. Zur Realisierung dieser Vormultiplikation muß zunächst das Vormultiplikations-Polynom $p_1(x)$ berechnet werden, das sich als Divisionsrest bei der Division des Polynoms $x^{r+i}$ durch das Generatorpolynom g(x) ergibt:

$$p_1(x) = \text{Rest} \left\{ x^{r+i} : g(x) \right\}$$

Die Koeffizienten von $p_1(x)$ bestimmen die Stellen, an denen das Empfangswort in das Syndromregister über Exklusiv-ODER-Gatter eingegeben werden muß.

Bei der bekannten Korrekturanordnung für den verkürzten Blockcode sind selbst bei einer Verkürzung um nur wenige Bits gegenüber der Korrekturanordnung für den unverkürzten Code im allgemeinen mehrere zusätzliche Exklusiv-ODER-Gatter erforderlich.

Aufgabe der Erfindung ist es, eine Korrekturanordnung für den verkürzten Blockcode anzugeben, die weniger Exklusiv-ODER-Gatter erfordert.

Ausgehend von einer Anordnung der einleitend geschilderten Art wird diese Aufgabe erfindungsgemäß dadurch gelöst, daß der Gesamteingang über wenigstens ein zwischen die Stufen des Syndromregisters geschaltetes Exklusiv-ODER-Gatter, dessen Lage aus den Koeffizienten eines Vormultiplikationspolynoms $p_2(x)$ abgeleitet ist, an das Syndromregister angeschlossen ist, daß sich das Vormultiplikationspolynom $p_2(x)$ als Divisionsrest bei der Division des Polynoms $x^{b+i}$ durch das Generatorpolynom $g(x)$ ergibt, daß die Nullen-Erkennungseinrichtung an die letzten $(r-b)$ Stufen des Syndromregisters angeschlossen ist und daß der Ausgang des Syndromregisters hinter seiner b-ten Stufe vorgesehen ist.

Die erfindungsgemäße Anordnung ist auch zur Korrektur von Einzelfehler korrigierenden zyklischen Blockcodes geeignet, wenn die Bündelfehlerlänge $b=1$ gesetzt wird.

Anhand von Ausführungsbeispielen wird die Erfindung nachstehend näher erläutert.

Fig. 1 zeigt ein Prinzipschaltbild der erfindungsgemäßen Anordnung und

Fig. 2 zeigt ein Syndromregister für einen um vier Bits verkürzten (279,265)-Fire-Code ($n=279$, $k=265$).

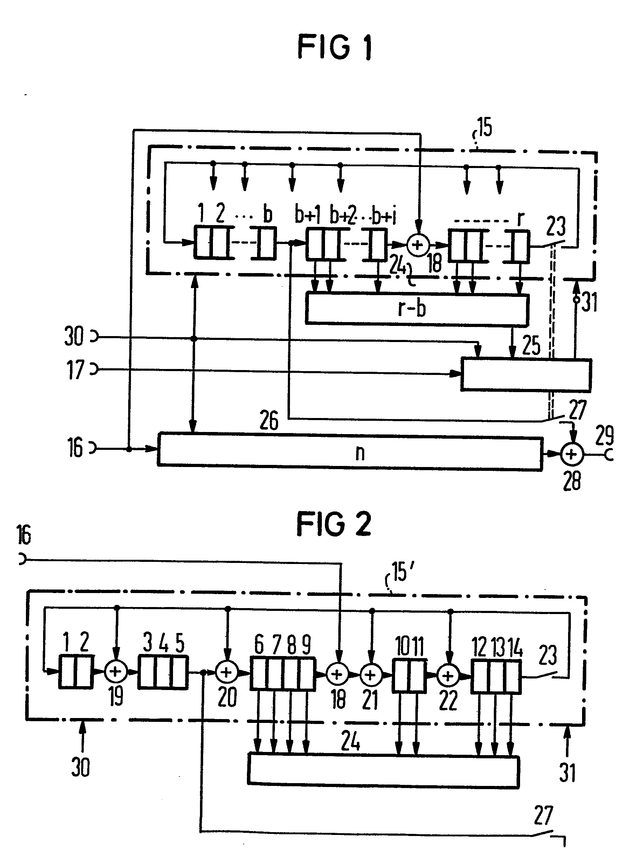

Figur 1 zeigt das Prinzipschaltbild der erfindungsgemäßen Korrekturanordnung. Diese enthält ein Syndromregister 15 mit Rücksetzeingang 31, eine Nullen-Erkennungseinrichtung 24, eine Ablaufsteuerung 25, einen Pufferspeicher 26, einen Schalter 27, ein Exklusiv-ODER-Gatter 28, einen Eingang 16, einen Ausgang 29, einen Synchronsignaleingang 17 und einen Takteingang 30.

Das Syndromregister 15 enthält ein Schieberegister mit
r = n-k Stufen, das über einen Schalter 23 mit verschiedenen Stufeneingängen gekoppelt ist. Der Eingang 16 ist
über das Exklusiv-ODER-Gatter 18 mit dem Syndromregister 15 verbunden; der Ausgang dieses Syndromregisters
15 führt zum Schalter 27.

Die Schalter 23 und 27 können als Gatter ausgebildet
sein.

Für die Figuren 1 und 2 wurden dieselben Bezugszeichen
gewählt. In Figur 1 nicht auftauchende Bezugszeichen
finden sich in Figur 2. Das Eingangssignal sei fehlerhaft.

Die Korrekturschaltung nach Figur 1 wirkt wie folgt:
In den Eingang 16 wird ein n-stelliges Codewort eingegeben und zwar sowohl in das Syndromregister 15, das
vor der Eingabe des Codeworts auf Null gesetzt wurde,
als auch in den Pufferspeicher 26. Der Inhalt des Syndromregisters 15 läuft über die Rückkopplungsschleife
um, bis das gesamte Codewort eingegeben ist. Jetzt folgen über den Eingang 16 n Nullen nach. Im Syndromregister läuft der Inhalt jetzt solange um, bis die Nullen-
Erkennungseinrichtung 24 in den Stufen (b+1) bis r ausschließlich Nullen erkennt. Jetzt wird über die Ablaufsteuerung 25 der Schalter 23 geöffnet und der Schalter
27 geschlossen. Vom Ausgang des Syndromregisters 15
nach der b-ten Stufe läuft jetzt der Inhalt der b Stufen, die das Fehlerbündel enthalten, über den Schalter
27 zum Exklusiv-ODER-Gatter 28, wo sie an der     Fehlerstelle  die aus dem Pufferspeicher 26 ausgelesenen
Bits korrigieren.

Hat die Nullen-Erkennungseinrichtung 24 nach n Verschiebungen während der Korrekturphase nicht angesprochen, so lag ein nicht korrigierbarer Fehler vor. Nach
der n-ten Verschiebung wird das Syndromregister 15 auf Null gesetzt und das nächste Codewort wird eingegeben.

Ein nicht korrigierbarer Fehler liegt vor, wenn das Fehlerbündel länger als b ist oder wenn mehr als ein Fehlerbündel pro Codewort auftritt.

Wenn die Codewörter in unmittelbarer Folge übertragen werden, so sind, wenn der Schiebetakt der Register 15, 26 gleich dem Bittakt der empfangenen Codewörter ist, zwei Syndromregister erforderlich, die alternierend arbeiten.

Das Synchronisationssignal am Eingang 17 kann in irgend einer Form aus dem Codewort am Eingang 16 abgeleitet werden.

Figur 2 zeigt ein Syndromregister 15' für einen um i=4 Bits verkürzten (279,265)-Fire-Code mit dem Generatorpolynom

$$g(x) = x^{14} + x^{11} + x^9 + x^5 + x^2 + x^0,$$

der eine Bündelfehler-Korrekturkapazität von b = 5 hat. Da n = 279 und k = 265 ist r = 14. Das Syndromregister enthält also Stufen 1 bis 14.

Entsprechend den Exponenten des Generatorpolynoms g(x) liegen die Rückkopplungen vom Ausgang der Stufe 14, am Eingang der Stufe 1 und hinter den Stufen 2, 5, 9 und 11. Die Einkopplungen bewirken Exklusiv-ODER-Gatter 19 bis 22.

Für das Vormultiplikationspolynom zur Codeverkürzung gilt

$$p_2(x) = Rest\left\{ x^{b+1} = g(x) \right\} = x^9$$

Der Eingang 16 des Syndromregisters 15' liegt also hinter der Stufe 9. Die Einkopplung erfolgt über das

0159403

- 7 -     VPA   84 P 1 3 3 2 DE

Exklusiv-ODER-Gatter 18. Der Ausgang des Syndromregisters liegt wegen b = 5 hinter der Stufe 5.

1 Patentanspruch

2 Figuren

0159403

Patentanspruch

Anordnung zur Korrektur von Bündelfehlern mit maximal b Stellen nach dem "Error-Trapping"-Verfahren in um i Stellen verkürzten zyklischen Blockcodes mit n Stellen die sich aus r Stellen für einen Prüfteil und aus k Stellen für einen Informationsteil zusammensetzen, mit einem r Stufen (1-14) aufweisenden Syndromregister (15, 15'), bei dem ein Gesamteingang (16) über wenigstens ein zwischen diese Stufen (1-14) geschaltetes Exklusiv-ODER-Gatter (18) angeschlossen ist, dessen Lage aus den Koeffizienten eines Vormultiplikationspolynoms abgeleitet ist und bei dem der Ausgang der letzten Stufe (14) über einen ersten Schalter (23) mit dem Eingang der ersten Stufe (1) und über wenigstens ein weiteres zwischen diese Stufen (1-14) geschaltetes Exklusiv-ODER-Gatter (19-22) mit weiteren Stufen verbunden ist, dessen Lage aus dem Generatorpolynom des Codes abgeleitet ist,

mit einer r-b Stufen aufweisenden und an Stufen des Syndromregisters (15, 15') angeschlossenen Nullen-Erkennungseinrichtung (24),

mit einem n Stufen aufweisenden und an den Gesamteingang (16) angeschlossenen Pufferspeicher (26),

mit einem letzten Exklusiv-ODER-Gatter (28), dessen einer Eingang mit dem Ausgang des Pufferspeichers (26), dessen anderer Eingang über einen zweiten Schalter (27) mit dem Ausgang des Syndromregisters (15, 15') und dessen Ausgang mit einem Gesamtausgang (29) verbunden ist, mit einer alle Schalter (23, 27) mit einem Synchronisierungssignal am Gesamteingang (16) synchronisiert betätigenden Ablaufsteuerung (25),

und mit einer mit dem Bittakt des am Gesamteingang (16) anliegenden Empfangssignals synchronisierten Taktversorgung (30),

d a d u r c h   g e k e n n z e i c h n e t ,

daß der Gesamteingang (16) über wenigstens ein zwischen die Stufen (1-14) des Syndromregisters (15, 15') geschaltetes Exklusiv-ODER-Gatter (18), dessen Lage aus den Koeffizienten eines Vormultiplikationspolynoms $p_2(x)$ abgeleitet ist, an das Syndromregister (15') angeschlossen ist,

daß sich das Vormultiplikationspolynom $p_2(x)$ als Divisionsrest bei der Division des Polynoms $x^{b+i}$ durch das Generatorpolynom $g(x)$ ergibt,

daß die Nullen-Erkennungseinrichtung (24) an die letzten r-b Stufen (6-14) des Syndromregisters (15, 15') angeschlossen ist und

daß der Ausgang des Syndromregisters (15, 15') hinter seiner b-ten Stufe (5) vorgesehen ist.

0159403

1/1

## FIG 1

## FIG 2